# EUROPEAN PATENT APPLICATION

(11) **EP 0 817 284 A1**
(43) Date of publication of application: **07.01.1998**
(21) Application number: 96304679.2
(22) Date of filing: 25.06.1996
(51) Int. Cl.: H01L 39/12

(54) **Superconducting structure**

(71) Applicant: HITACHI EUROPE LIMITED, Maidenhead, Berkshire, SL6 8YA (GB)
(72) Inventor: Williams, David Arfon, Cambs CB2 1NN (GB); Marsh, Adrian M., Hardwick, Cambs CB3 7XU (GB); Ahmed, Haroon, Cambs (GB)
(74) Representative: Geary, Stuart Lloyd

(57) **Abstract**

A superconducting structure comprises nanometre-scale particle or network links embedded in a matrix. The particles or network links are formed of material which is capable of superconduction whereas the matrix is not. The matrix is preferably flexible or ductile.

## Description

The present invention relates to a superconducting structure comprising a first material capable of superconduction embedded in a matrix of a second material which is ductile or flexible but incapable of superconduction.

An aim of the present invention is to provide a novel superconducting structure.

A superconducting structure, according to a first aspect of the present invention, is characterized in that the embedded material comprises particles having dimensions no larger than 1000 nanometres or links of a network having transverse dimensions no larger than 1000 nanometres. The embedded material may not necessarily be inherently superconducting as long as superconduction can be induced therein, for example by the injection of phonons.

A structure, according to a second aspect of the present invention, is characterized in that the embedded material comprises nanometre-scale structures arranged to provide a superconductive path through the matrix. Nanometre-scale means that the dimensions of the particles are such that they can be conveniently expressed in nanometres.

If the embedded material comprises particles, the particles need not actually be in contact with each other so long as they are proximity-linked.

An alloy of tin, for example a tin-gold alloy, may be used for the first material and the second material may be chromium.

A problem addressed, by one class of embodiments of the present invention, is that of the brittleness of high T_{c} ceramic superconductors. In these embodiments, the first material comprises a ceramic superconductor embedded in a metallic matrix. The resulting structure will have substantially the ductility and flexibility of the metal forming the matrix.

The particles, network or structures may be formed from organic molecules. The matrix may comprise a polymer.

Certain types of radiolarian-like microorganisms for a skeleton of single-crystal branching stellated and spherical structures. The natural skeletons may be induced to become superconducting. Alternatively, similar structures may be grown as superconductors. The growth of radiolarian-like structures is discussed in "Spheres of Influence", Nature, 2 Dec 1995, pp 42 - 45. These structures may be embedded in a matrix which would preferably be flexible.

A more rigid structure may be fabricated using semiconductor processing techniques. Such a structure may have one or more grid-like superconducting layers with matrix material deposited between the elements of the grid-like structures.

Embodiments of the present invention will now be described, by way of example, with reference to the accompanying drawings in which:
Figure 1 shows the surface of a contact before and after annealing;
Figure 2 shows a cross-section of a contact;
Figure 3 shows further cross-sectional views of a contact;
Figure 4(a) is an electron micrograph of an annealed contact;
Figure 4(b) is an electron micrograph of an Sn₄Au region shown in Figure 4(a);
Figure 4(c) shows a diffraction pattern from Sn₄Au;
Figure 5 is a schematic of a radiolarian-like object; and
Figure 6 shows a nanofabricated structure according to the present invention.

The present invention arose as a by-product of the formation of contacts on a semiconductor substrate for the study of Andreev reflection. The formation of a contact having surprising superconducting properties will be described first.

A GaAs:AlGaAs heterostructure was grown by molecular epitaxy. The heterostructure produced had electron mobilities in the range 10⁵ to 2 x 10⁶ cm² v⁻¹ s⁻¹. A 250nm-thick layer of tin was formed over the cleaned surface of the substrate. A 100nm-thick layer of chromium was formed over the tin layer and finally a 60nm-thick layer of gold was formed over the chromium layer. Each of these layers was deposited using a thermal evaporation technique.

After deposition, the metal layers were sintered in an electron-beam rapid thermal annealing system. The thermal cycle used a very rapid heat-up followed by exponential cooling with a peak temperature of approximately 630°C being held for 10ms.

The purpose of the multilayer structure was that the tin should act as the superconductor and also dope the semiconductor and the chromium should act as a refractory layer to hold the tin in place during annealing. If a refractory layer is not used, tin will flow across the semiconductor surface, potentially shorting contacts which can be as close as 1 µm. The gold layer was added to minimize oxidation of the chromium, and ensure good electrical contact to further layers of metallisation.

Various contacts were formed by the process described above. Their electrical characteristics were measured at temperatures from 50mK to room temperature, with and without an applied magnetic field. The contacts were found to have a spread of critical temperatures, with a significant number having a T_{c} of 7.2K. This is markedly higher than that of bulk elemental tin (3.4K).

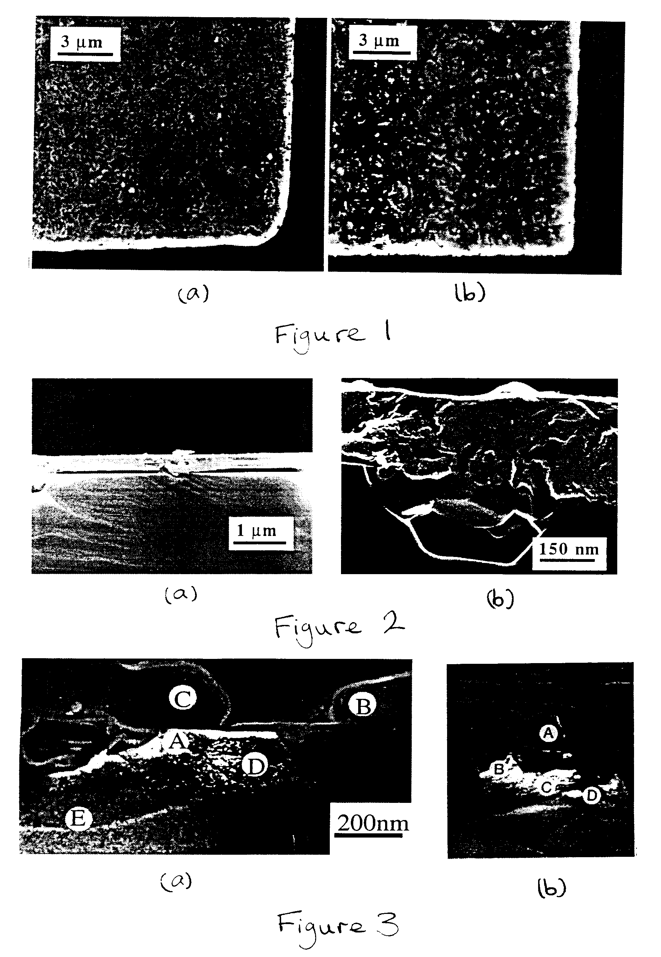

The contacts were analyzed using cross-sectional and planar high-resolution SEM, and cross-sectional TEM. The morphology before and after annealing is shown in Figure 1. The deposited metal layer can be seen to be uneven, the main cause of which was the granular growth of the tin layer. After annealing, the contact structure was grossly uneven, and the appearance had changed from gold to silver. Cross-sectional TEM showed the material to be largely polycrystalline to a depth of around 250nm. The chromium layer, rather than entirely remaining in place as a refractory cap, had alloyed with the other materials present as had, to some degree, the gold.

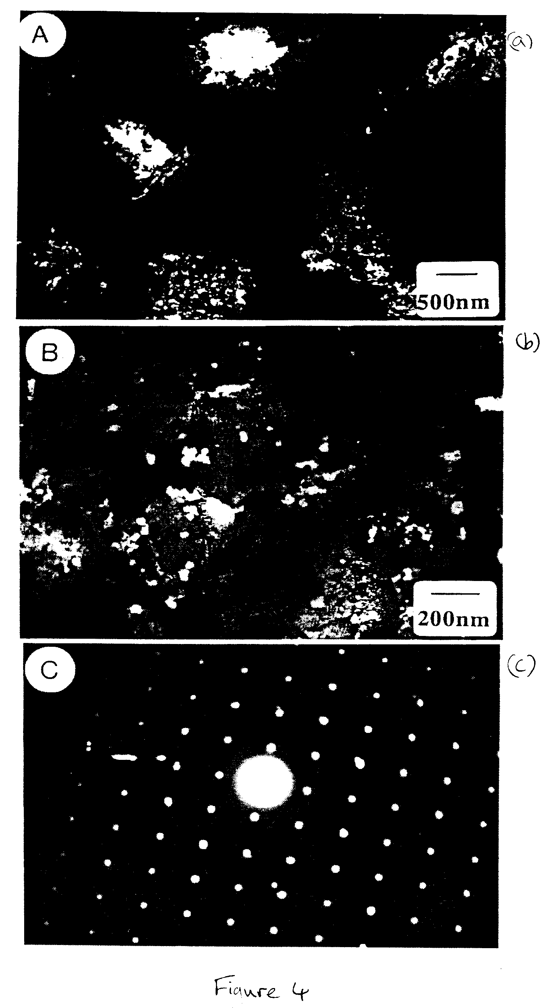

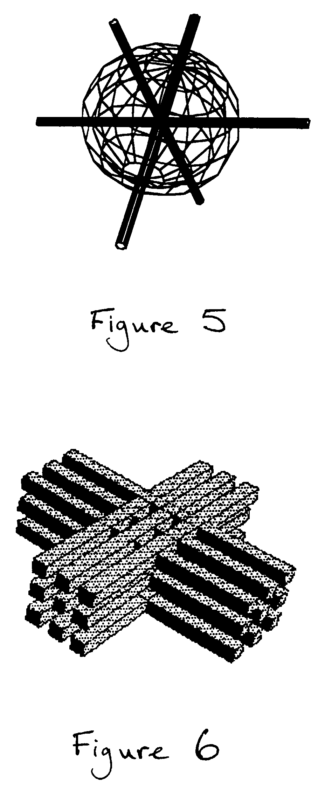

The alloy phases going downwards from the surface were found to retain partial orientation relationships with the substrate, and were occasionally but not usually faceted. Voiding was seen in many places, both in the surface metal layer and in the substrate, and can be seen in cross-sections in Figures 2 and 3, and as holes and bubbles in plan view in Figure 1(b). A rounded trapezoidal grain, as seen in Figure 2(b) and at position D in Figure 3(b) was common, and is reminiscent of the 'spikes' seen in annealed Au:Ge:Ni ohmic contacts to GaAs. The voiding is believed to be due to the formation of gaseous arsenic during the anneal, a process which is also seen in Au:Ge:Ni contact formation by rapid thermal annealing.

Compositional analysis shows that there were many alloy phases present, and a large proportion of the alloy present in the downward reaction product was CrAs based. Figure 3 shows evidence of small localised particles in a region of the substrate GaAs which shows changes in local lattice parameters and As depletion. The edge of this region of altered lattice parameter was sometimes decorated with a reaction product, as can be seen at point E in Figure 3(a). There was evidence of Ga up-diffusion, and the Au was predominantly near the surface, although some had diffused downwards.

The cross-sectional structure of the contact after annealing can be seen in Figure 3 and is highly heterogeneous. The contact metal had extensively alloyed with the semiconductor to a depth in excess of 200nm in some regions. The structure was polycrystalline, with considerable faceting and voiding, and there was no trace of the original heterostructure visible under most of the contact. Other regions showed much less intermixing. Energy-dispersive X-ray analysis (EDX) was used to assess the elemental composition of vanous regions.

Several alloy phases can be seen, with a predominance of an alloy of Sn₄Au, in a matrix which is chromium-rich and has a large proportion of CrAs. There is evidence in some regions of arsenic depletion from the GaAs up to 2µm from the surface, but again this was not uniform across the sample. Many aspects of the general morphology are similar to those of gold:germanium:nickel ohmic contacts to GaAs heterostructures formed by the same annealing process, although the optimised annealing conditions are slightly different for the two materials. In particular, there is considerable evidence of rounded trapezoidal inclusions, qualitatively similar to the spikes seen in Au:Ge:Ni contacts, but shallower and broader.

Figure 4 shows planar transmission electron micrographs of the contact material. Figure 4(a) is a low magnification dark field micrograph of a region exhibiting a fairly uniform honeycomb structure. EDX analysis of the various regions shows the thinner regions to be a gold-tin compound with a concentration ratio of 1:4. A comparison of the equilibrium phase diagram for Au:Sn and the diffraction patterns obtained for this phase confirms that this is almost certainly AuSn₄, which is orthorhombic with a=0.6445 nm, b=0.6487 nm and c=1.1599 nm. The diffraction patterns obtained fitted this to an accuracy of 1.5%, the discrepancy probably being due to the addition of a component of gallium. Figure 4(b) shows a higher magnification view of this phase, showing from the moire and misfit dislocation arrays that there were a number of complex sub-grain arrays. The thicker regions seen in the upper micrograph are predominantly chromium.

The equilibrium phase diagrams of these alloy systems show that there is a competition between two alloying processes - tin-gold and tin-arsenic. Although the strongly non-quilibrium nature of the rapid annealing process means that the equilibrium phase diagrams should be used with caution, the most common tin reaction product is Sn₄Au, and a small amount of Sn-As was found.

The microstructure of the contacts can be linked to the electron transport properties. In particular, the existence of the mutiply-connected tin-based superconductor in a chromium-rich matrix is an indicator of the magnetic-field response. The contacts show evidence of excess current up to applied fields of ∼6T at 1.6K, which is believed to be a consequence of two effects. One is the multiply interconnected nature of the superconductor, with an interconnecting normal region. The normal regions, interspersed on a scale of a few hundred nanometres, are believed to be acting as a flux sink, allowing the superconductor to remain superconducting to higher fields than would be possible in a uniform film with random and weakly pinned flux penetration.

Oxide superconductors have relatively high critical temperatures, but they are very brittle ceramic materials. The present invention provides a solution to this problem. Here, the embedding of crystals of such a material in a rather more ductile matrix, but where the crystals are sufficiently close together that they are proximity-linked, allows the formation of a high critical-temperature material that can be used in realistic applications, and which would have the added advantage of inherently higher critical field.

It has recently been predicted that superconductivity may be inducible in materials using injected phonons. However, the usefulness of this phenomenon has appeared to be limited because it has been difficult in practice to design a structure in which the required phonon distribution could be sustained. The present invention provides solutions to this problem.

A structure according to the present invention would contain features small enough to show phonon localisation, which would be embedded in a matrix of normal material. The matrix would increase the ductility and the directional response of the conductivity.

Molecules provide a suitable paradigm for a localised system which could be used in this context. Some molecules are naturally superconducting, and others are strong candidates for phonon-induced superconductivity. In either case, the superconducting molecule, or molecular cluster, could be embedded in a suitable matrix. In the case of chain organic molecules, the matrix would be a conducting polymeric system.

Certain types of radiolarian-like microorganisms form a skeleton of single-crystal branching stellated and spheroidal structures. These are potentially inducible as artificial superconductors, or growable as superconductors, and could again be embedded in a relatively flexible matrix. Figure 5 shows such a structure.

The structures described above all use a natural interconnected granularity to produce the required structure. This type of geometry also can be formed by lithographic means, using the well-established techniques of optical, electron-beam or X-ray lithography. One material, for example the superconductor, can be patterned in an array, for example a grid. A second material can then be deposited on top, and patterned, and a three-dimensional interconnected structure built up, with pattern dimensions appropriate to the materials parameters desired. Figure 6 illustrates a suitable structure with the matrix material omitted.

## Claims

1. A superconducting structure comprising a first material capable of superconduction embedded in a matrix of a second material which is ductile or flexible but incapable of superconduction, **characterized in that** the embedded material comprises particles having dimensions no larger than 1000 nanometres or links of a network having transverse dimensions no larger than 1000 nanometres.

2. A superconducting structure comprising a first material capable of superconduction embedded in a matrix of a second material which is ductile or flexible but incapable of superconduction, **characterized in that** the embedded material comprises nanometre-scale structures arranged to provide a superconductive path through the matrix.

3. A structure according to claim 1 or 2, wherein said particles or structures are discrete but are proximity-linked.

4. A structure according to claim 1, 2 or 3, wherein the first material comprises tin.

5. A structure according to claim 4, wherein the first material comprises an alloy of tin.

6. A structure according to claim 5, wherein the alloy is an alloy of tin and gold.

7. A structure according to claim 1, 2 or 3, wherein the first material comprises a ceramic superconductor.

8. A structure according to any preceding claim, wherein the second material is metallic.

9. A structure according to claim 7, wherein the second material comprises chromium.

10. A structure according to claim 1 or 2, wherein said particles, network links or structures comprise organic molecules and the second material comprises a polymer.

11. A structure according to claim 1 or 2, wherein the first material comprises a substantially mono-crystalline radiolarian-like structure.

12. A structure according to claim 1 or 2, wherein said network or structures are formed on a substrate by successive lithography and depositions steps.

13. A structure according to claim 1 or 2, wherein the first material is configured into a network and is capable of phononically induced superconduction.
